# EUROPÄISCHE PATENTSCHRIFT

(11) **EP 3 101 500 B1**
(45) Veröffentlichungstag und Bekanntmachung des Hinweises auf die Patenterteilung: **14.02.2024**
(21) Anmeldenummer: 15170297.4
(22) Anmeldetag: 02.06.2015
(51) Int. Cl.: G05B 19/418

(54) **STEUERSYSTEM FÜR EINE VERTEILTE PROZESSSTEUERUNG EINER TECHNISCHEN ANLAGE UND EIN VERFAHREN ZUR STEUERUNG EINER TECHNISCHEN ANLAGE**
CONTROL SYSTEM FOR A DISTRIBUTED PROCESS CONTROL OF A TECHNICAL INSTALLATION AND A METHOD FOR CONTROLLING A TECHNICAL INSTALLATION
SYSTÈME DE COMMANDE POUR UNE COMMANDE DE PROCESSUS RÉPARTIE D'UNE INSTALLATION TECHNIQUE ET PROCÉDÉ DE COMMANDE D'UNE INSTALLATION TECHNIQUE

(43) Veröffentlichungstag der Anmeldung: 07.12.2016
(73) Patentinhaber: Siemens Aktiengesellschaft, 80333 München (DE)
(72) Erfinder: Heck, Christian, 75196 Remchingen (DE); Wolf, Gerrit, 76187 Karlsruhe (DE)
(74) Vertreter: Siemens Patent Attorneys

(56) Entgegenhaltungen:
- EP-A1- 2 169 596
- EP-A2- 2 660 667
- EP-A2- 2 821 867
- WO-A1-2014/090310
- DE-A1-102014 103 353
- US-A1- 2010 256 795
- US-A1- 2010 257 228
- MUNTEAN IONUT ET AL: "Remote Management: An Architecture for Mechatronic Systems", 2013 IEEE 10TH INTERNATIONAL CONFERENCE ON E-BUSINESS ENGINEERING, IEEE, 11. September 2013 (2013-09-11), Seiten 498-503, XP032534345, DOI: 10.1109/ICEBE.2013.78 [gefunden am 2013-12-17]
- CAYIRCI ERDAL: "Modeling and simulation as a cloud service: A survey", 2013 WINTER SIMULATIONS CONFERENCE (WSC), IEEE, 8. Dezember 2013 (2013-12-08), Seiten 389-400, XP032559276, DOI: 10.1109/WSC.2013.6721436 [gefunden am 2014-01-23]
- Kyle Wilhoit: "SCADA in the Cloud A Security Conundrum?", , 31. Dezember 2013 (2013-12-31), Seiten 1-11, XP055223954, Gefunden im Internet: URL:http://www.trendmicro.com/cloud-conten t/us/pdfs/security-intelligence/white-pape rs/wp-scada-in-the-cloud.pdf [gefunden am 2015-10-27]

## Beschreibung

Die Erfindung betrifft ein Steuersystem für eine verteilte Prozesssteuerung einer technischen Anlage und ein Verfahren zur Steuerung einer technischen Anlage.

Eine Vielzahl von Anlagen, die eine Prozesssteuerung vornehmen, erfüllt in der Regel einfache automatisierungs- und regelungstechnische Aufgaben. Diese sind mit Regelgrößen im Sekundenbereich sehr oft auch nicht zeitkritisch. Als ein Beispiel sei hier die Wasseraufbereitung in Kläranlagen genannt, weitere Beispiele ist das Leitungsmanagement für verschiedene Leitungssysteme (Gas, Öl, Wasser), die Trocknung von Zwischenerzeugnissen der Nahrungsindustrie (Speiseöltrocknung, Getreidetrocknung) oder die Fertigung von Gläsern, das Ziehen von Einkristallen oder generell Flotationen. Oft bestehen solche Anlagen dann auch aus einer Vielzahl meist auch räumlich getrennter, kleinerer Automatisierungseinheiten, was dann zur Folge hat, dass auch die einzelnen Prozessaufgaben verteilt ablaufen. Solche kleineren Automatisierungseinheiten sind aufgrund ihrer eingeschränkten Rechenleistung eher nicht in der Lage komplexe Regelungsstrukturen oder Regelungs- und/oder Simulationsstrategien abzubilden, wie sie in Automatisierungsgeräten der höheren Klassen möglich sind. Solche komplexeren Regelungsstrategien, die eine erhebliche Rechenkapazität benötigen können, können beispielsweise sogenannte modellprädiktive Regelungen (Model Predictive Control, MPC) sein, wie sie bevorzugt in verfahrenstechnischen Prozessen eingesetzt werden. Häufig besteht auch der Wunsch Simulationsmodelle einzurichten, um auf dieser Basis Optimierungen am Prozess vornehmen zu können. Deshalb werden solche rechenintensiven verfahrenstechnische Prozesse oder Simulationsmodelle häufig im übergeordneten Steuerungs-, und Überwachungssystem der Anlage automatisiert. Dennoch ist es der Wunsch, dem dezentralen Anlagengedanken folgend, solche verfahrenstechnischen Prozesse oder auch Simulationsstrategien vor Ort und somit prozessnah zu implementieren, auch wenn die prozessnahen Automatisierungseinheiten dies aufgrund ihrer eingeschränkten Rechenkapazität nicht zulassen. Der Vorteil solcher prozessnahen Lösungen liegt auf der Hand, denn sie reduzieren die Gesamtkomplexität und machen das System unanfälliger gegenüber Störungen. Deshalb werden heute vor allem parallel geschaltete Vorortlösungen eingesetzt, um bestehende Systeme in ihren Automatisierungsfunktionen zu erweitern. Ein großer Nachteil solcher Lösungen ist der Preis, der vor allem durch die zusätzliche Hardware und den notwendigen Service entsteht. Denn solche Lösungen müssen vor Ort gewartet werden. Eine solche Wartung ergibt sich oft schon aus der Anpassung seiner Parameter, z.B. aufgrund von Veränderungen im Prozessverhalten wie sie sich beispielsweise schon ergeben können aus Veränderungen bei Stellgliedern (Ventile, Schieber) oder Rohrleitungen durch Veränderungen ihrer Kennlinien im Laufe der Zeit z.B. durch Ablagerungen oder aber allgemeiner Verschiebungen des dynamischen Verhaltens.

Aus dem Artikel "Remote Management: an Architecture for Mechatronic Systems" von Ionut Muntean et al. (2013 IEEE 10th International Conference on e-Business Engineering(2013), S. 498 - 503, IEEPAD ISBN 978-0-7695-5111-1) ist eine Anordnung mit einem mechatronischen System, einer Cloud sowie Usern bekannt, die miteinander wechselwirken. Das mechatronische System weist einen Prozess auf, wobei Prozess- bzw. Analysedaten von dem mechatronischen System an die Cloud übermittelt werden und die Cloud Steuersignale an das mechatronische System übermittelt. Hierzu weist die Cloud Steuerprogramme auf, die in den Anwendungen angeordnet sind.

Eine solche Vorrichtung und ein solches Verfahren sind aus dem Dokument EP2660667 bekannt.

Es ist somit Aufgabe der Erfindung eine Vorrichtung und ein Verfahren anzugeben, welche kostengünstig und weitestgehend nicht-intrusive funktionale Erweiterungen und Verbesserungen von Prozessanlagen ermöglichen.

Die Aufgabe wird gelöst durch ein System mit den Merkmalen des Anspruchs 1. Danach weist das System zur Steuerung eines Prozesses anlagenseitig wenigstens eine Automatisierungseinheit auf. Anlagenseitig heißt, dass die Automatisierungseinheit Bestandteil des originären Automatisierungssystems ist und in der Regel prozessnah angeordnet ist. Die Automatisierungseinheit führt eine Anzahl erster Prozessgrößenberechnungen durch. Dazu ist die Automatisierungseinheit mittels Sensoren und Aktoren in den Prozess eingebunden und wirkt auf diesen durch ihre Prozessgrößenberechnungen ein. Mittels einer ersten Datenverbindung ist die Automationseinheit mit einem übergeordneten Überwachungssystem zur Steuerung und/oder Überwachung des Prozesses verbunden ist. Das System weist weiter wenigstens eine anlagenexterne Recheneinheit auf, die über verteilte Kommunikationsmechanismen auf die wenigstens eine Automatisierungseinheit aufgeschaltet ist, d.h. mit diese Nachrichten austauschen kann. Als anlagenextern soll eine Recheneinheit angesehen werden, wenn sie räumlich und/oder funktional außerhalb des originären Automatisierungssystems angesiedelt ist. Solche anlagenexternen Recheneinheiten können sich z.B. bei externen Serviceprovidern befinden. Der Datenaustausch erfolgt über eine zweite Datenverbindung. Zu den verteilten Kommunikationsmechanismen gehören beispielsweise die Kommunikationsstandards OPC (OPC DA, OPC UA) oder TCP/IP (Profinet), die den Zusammenschluss unabhängiger Recheneinheiten zu einem verteilten System erlauben. Die anlagenexterne Recheneinheit führt eine Anzahl zweiter Prozessgrößenberechnungen durch. Diese Berechnungen werden über die Automatisierungseinheit prozesswirksam. D.h. die Automatisierungseinheit steuert den Prozess auf Basis von Berechnungen, die in der anlagenexternen Recheneinheit durchgeführt worden sind. Die Berechnungen, die in der anlagenexternen Recheneinheit durchgeführt werden, sind weit komplexer und rechenintensiver als diejenigen, die in der anlagenseitigen Automatisierungseinheit durchgeführt werden können. So übernimmt die externe Recheneinheit erweiterte regelungstechnische Funktionen, wie sie beispielsweise von MPC-Reglern bekannt sind. Weiterhin können auch Condition Monitoring Systeme, Simulationssysteme oder Historiensysteme innerhalb dieser Recheneinheit zusätzliche Auswertungen durchführen und zu diesem Zwecke auch auf die durch die Regelung verarbeiteten Signale zurückgreifen. Mit den vorgenannten Systemen, d.h. aufgrund von Ergebnissen der vorgenannten Systeme - beispielsweise wenn Abweichungen vom Sollverhalten gegebenenfalls basierend auf historischen Daten festgestellt werden, lassen sich wiederum sehr vorteilhaft die Regelungsparameter anpassen. Diese Parameter wiederum können über die anlagenseitige Automatisierungseinheit prozesswirksam werden. Durch das Setzen solcher Parameter aus der Ferne bedarf es keines Serviceteams vor Ort an der Anlage. Mit Hilfe vorgenannter Simulationsmodelle der Anlage können Vorwegstrategien und/oder Optimierungen des Prozesses vorgenommen werden. Nach erfolgreichem Test können diese dann auf der anlagenexternen Recheneinheit online geschaltet werden.

Die Vorteile eines solchen Systems liegen auf der Hand. Eine Erweiterung bestehender Anlagen um neue Automatisierungsalgorithmen und -methoden und damit eine Optimierung dieser bezüglich Energieverbrauch, Qualität, Arbeitsdauer usw. ist kostengünstig möglich, da es keiner zusätzlichen Hardware vor Ort und damit keiner aufwendigen Installation und Pflege der Hardware bedarf. Darüber hinaus ist eine verteilte Wartung und Pflege von verteilten Automatisierungskomponenten von einem Ort aus möglich. Dabei kann die kontinuierliche Betriebsführung sichergestellt werden. Die Optimierung von Regelungen auf Basis von Simulationen, welche über die Lebenszeit der Anlage mitlernen und somit ebenfalls optimiert werden können ist möglich.

Es hat sich als vorteilhaft erwiesen, Simulationsaufgaben abgebildet in Simulationsmodellen in einer weiteren anlagenexternen Recheneinheit ablaufen zu lassen. Zu diesem Zwecke ist wenigstens eine weitere anlagenexterne Recheneinheit mit der ersten anlagenexternen Recheneinheit verbunden. Somit wäre es möglich ein Simulationsmodell über den Betrieb der Anlage hinweg mit Daten aus der Anlage, respektive aus dem Prozess, zu versorgen. Das Simulationsmodell kann auf diese Weise angepasst und optimiert werden und somit quasi selbst lernend das Wissen über den Prozess weiter präzisieren. Ein optimiertes Simulationsmodel kann dann wiederum das prädiktive Regelungskonzept verbessern und somit die gesamte Steuerung der Anlage. Auf diese Weise entstünde eine simulierte Schattenanlage, die beispielsweise wiederum für Migrationsszenarien der Anlagensteuerung (Erneuerung von Hardware) verwendet werden kann, oder aber für geplante Prozessveränderungen in der Anlage selbst. Sie könnten beispielsweise auch Grundlage einer virtuellen Inbetriebnahme sein.

Nach einem weiteren Aspekt können auf der externen Recheneinheit Simulationsmodelle vorgehalten werden, die unterschiedliche Optimierungsstrategien verfolgen. So kann in einer Optimierungsstrategie beispielsweise der Ausstoß einer Produktion optimiert sein, eine andere Optimierung hat den sparsamsten Umgang mit Energie oder Materialressourcen zum Gegenstand. Wieder andere könnten die Qualität und Güte eines Produktes in den Vordergrund setzen (z.B. Hexangehalt bei der Speiseöltrocknung oder Nitratgehalt des geklärten Abwassers).

Nach einem weiteren Aspekt sind die verschiedenen Optimierungsstrategien des Simulationsmodells oder der Simulationsmodelle dynamisch und reagieren auf externe Einflussfaktoren. Solche Einflussfaktoren können beispielsweise tagesaktuelle Preise für Rohstoffe und Energie, die Verfügbarkeit von Personal und deren Kosten aber auch online Börsen- oder Wetterdaten sein, die mit in das Regelungskonzept integriert werden. Dazu erhält die externe Recheneinheit eine Schnittstelle zu Service Providern, die solche Daten bereitstellen. In anderen Fällen sind solche Daten aus anderen Systemen (beispielsweise des Einkaufsystems) des Anlagenbetreibers selbst abrufbar. Sehr vorteilhaft kann der Anwender dann zwischen den einzelnen Optimierungsstrategien umschalten, um so die Regelungskonzepte auf die aktuellen Rahmenbedingungen anzupassen. Eine Umschaltung zwischen den einzelnen Optimierungsstrategien wäre auch zentral und automatisch möglich.

Die zweiten Prozessgrößenberechnungen der anlagenexternen Recheneinheit sind der anlagenseitigen Automatisierungseinheit überlagert. Auf diese Weise wird sichergestellt, dass die höherwertigeren und intelligenteren Regelungsstrukturen oder Optimierungsstrategien immer wirksam sind.

Erst bei Störung der zweiten Datenverbindung werden die Prozessgrößenberechnungen der anlagenseitigen Automatisierungseinheit ausgeführt, um auf diese Weise sicherzustellen, dass die Anlage im Falle einer Störung weiterbetrieben werden kann. Unter einer Störung der zweiten Datenverbindung sollen auch Störungen innerhalb der anlagenexternen Recheneinheit verstanden werden, die im Ergebnis keine oder fehlerhafte Daten an die Automatisierungseinheit liefern.

Wenn einer anlagenseitigen Automatisierungseinheit ein Serviceagent zugeordnet ist und der Serviceagent die anlagenexterne Recheneinheit mit Prozessdaten der anlagenseitigen Automatisierungseinheit versorgt, kann vorteilhaft über den Serviceagenten eingestellt werden, welche Prozessdaten in welchen Zeitintervallen an die externe Recheneinheit gesendet werden. Unter einen Serviceagenten soll in diesem Zusammenhang ein Subsystem verstanden werden, welches mit einer Datenquelle verbindbar ist und Daten sammelt. In der Regel wird der Agent als Softwareprodukt innerhalb des anlagenseitigen Automatisierungssystems laufen. Dabei ist der Serviceagent in der Lage über die verschiedensten Echtzeit Schnittstellen - beispielsweise SIMATIC NET OPC, OPC DA, OPC UA, Modbus oder SNMP - Daten einzusammeln oder Daten abzugreifen über Zugriffe auf bestimmte Dateien in denen Daten vom Automatisierungssystem abgelegt werden, beispielsweise *.csv oder *.xml Dateien. Über eine Schnittstelle kann der Anwender über sogenannte Scripts meist mit separatem Werkzeug festlegen, welche Daten zu welchen Zeiten er gesendet bekommen möchte und welche Vorbehandlung der Daten im Automatisierungsgerät stattfinden soll. Ein Prozessdatum (eine Messstelle) umfasst dabei idealer Weise neben dem Messstellenwert (analog oder digital) auch einen Zeitstempel und einen Qualitätscode. Die Abtastrate ist dabei variabel gestaltet beispielsweise zwischen einer Sekunde bis zu einem Tag. Eine entsprechende Vorbehandlung von Daten durch den Agenten bevor diese dann an die anlagenexterne Recheneinheit gesendet werden, ist insbesondere dann vorgesehen, wenn die zu sendenden Datenmengen begrenzt werden müssen und/oder komplexe Auslösebedingungen zu bewerten sind.

Die Aufgabe wird ferner gelöst durch ein Verfahren mit den Merkmalen des Anspruchs 9. Das Verfahren zur Erweiterung wenigstens einer anlagenseitigen Automatisierungseinheit zur Steuerung von Prozessgrößen mit einer Anzahl von weiteren Automatisierungsfunktionen basiert darauf, dass die zu erweiternde anlagenseitige Automatisierungseinheit eine Anzahl erster Prozessgrößenberechnungen umfasst und mittels einer ersten Datenverbindung mit einem Überwachungssystem zur Steuerung und/oder Überwachung des Prozesses verbunden ist. In einem ersten Schritt wird eine Anzahl von weiteren in der Regel komplexeren Automatisierungsfunktionen für eine Anzahl zweiter Prozessgrößenberechnungen in wenigstens einer anlagenexternen Recheneinheit programmtechnisch implementiert. Eine solche programmtechnische Implementierung von komplexeren Automatisierungsfunktionen umfasst insbesondere modellprädiktive Regelungskonzepte, die gepaart sein können mit Simulationssystemen für die Regelungskonzepte. In einem weiteren Schritt wird die anlagenexterne Recheneinheit über verteilte Kommunikationsmechanismen über eine zweite Datenverbindung auf die wenigstens eine anlagenseitige Automatisierungseinheit aufgeschaltet. Aufgeschaltet bedeutet in diesem Zusammenhang, dass über eine zweite Datenverbindung eine Verbindung zwischen anlagenseitigem Automatisierungsgerät und anlagenexterner Recheneinheit hergestellt wird und über diese Datenverbindung ein Datenaustausch zumindest für die notwendigen Prozessdaten zwischen den vorgenannten Objekten möglich wird. In einem weiteren Schritt werden dann die von der anlagenexternen Recheneinheit durchgeführten Prozessgrößenberechnungen parallel zu den Prozessgrößenberechnungen der anlagenseitigen Automatisierungseinheit durchgeführt. Allerdings werden die Prozessgrößenberechnungen der anlagenseitigen Automatisierungseinheit in dem Umfang unwirksam, in dem die zweiten Prozessgrößenberechnungen der anlagenexternen Recheneinheit wirksam werden und die Steuerung der anlagenseitigen Prozessgrößen mittels der zweiten Prozessgrößenberechnungen erfolgt, wobei die Prozessbeeinflussung über die anlagenseitige Automatisierungseinheit erfolgt, d.h. die Ausgänge der anlagenseitigen Automatisierungseinheit aufgrund der Berechnungen in der anlagenexternen Recheneinheit geschalten werden.

Nach einem weiteren Aspekt des vorgenannten Verfahrens wird die Steuerung von anlagenseitigen Prozessgrößen, d.h. die Steuerung des Prozesses selbst mittels der zweiten Prozessgrößenberechnungen überwacht. Die Überwachung erfolgt über das Überwachungssystem mit dem die anlagenseitige Automatisierungseinheit über die erste Datenverbindung verbunden ist. Eine solche Überwachung kann durch einen Abgleich der zweiten Prozessgrößenberechnungen mit den parallel laufenden ersten Prozessgrößenberechnungen erfolgen. In diesem Falle könnten Fehler von auf den Prozess wirkende Steuergrößen erkannt werden, wenn z.B. die Abweichungen einen vorgegebenen Differenzbetrag überschreiten. Im einfachsten Falle könnte aber auf diese Weise auch die zweite Datenverbindung auf ihre Funktionsfähigkeit anhand der Änderung der Prozessgrößen selbst überwacht werden.

Im Falle einer Störung beispielsweise durch einen Ausfall der externen Rechnereinheit oder einen Ausfall der zweiten Datenverbindung selbst ersetzen die ersten Prozessgrößenberechnungen die zweiten Prozessgrößenberechnungen und werden auf diese Weise prozesswirksam. D.h. sollte die Verbindung zur anlagenexternen Recheneinheit getrennt werden, übernimmt die Steuerung vor Ort die Aufgabe der Regelung wieder. Hierfür verwendet sie ihren bestehenden Algorithmus. Die Anlage läuft in diesem Fall zwar weniger effizient aber ein Schadensfall wird verhindert. Wenn die externe Recheneinheit wieder verbunden ist, schaltet das System wieder um.

Die oben beschriebenen Eigenschaften, Merkmale und Vorteile dieser Erfindung sowie die Art und Weise, wie diese erreicht werden, werden in Verbindung mit der Figur näher erläutert. Hierbei zeigen in schematischer Darstellung:

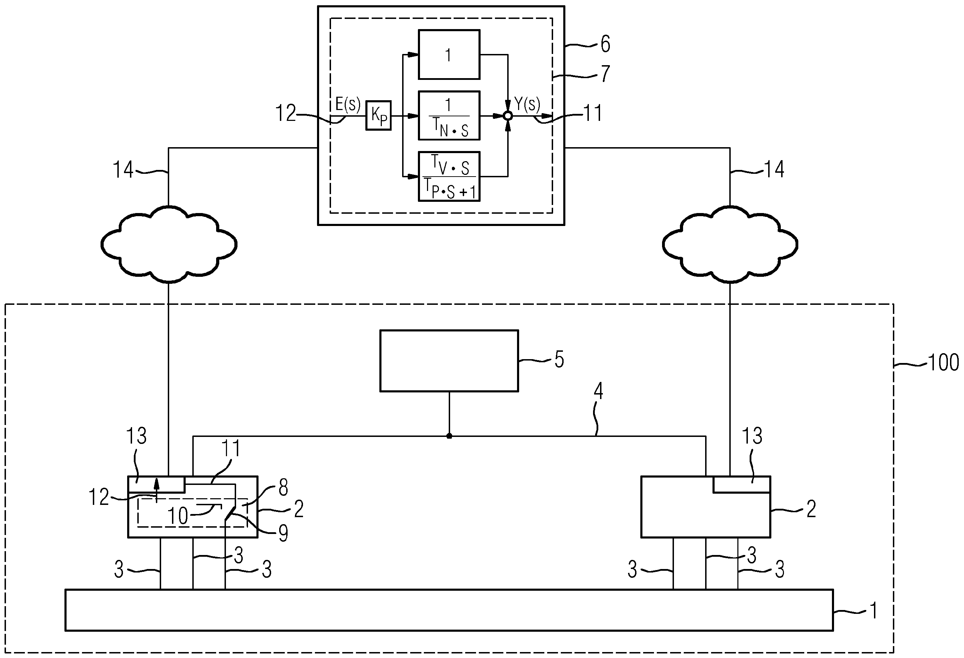

- Fig. 1: ein System für eine verteilte Prozesssteuerung einer technischen Anlage

Fig.1 zeigt ein System 100 zur Steuerung des industriellen Prozesses 1, beispielsweise einen Prozess zur Wasseraufbereitung in einer Kläranlage oder einem Prozess zur Förderung einer Flüssigkeit oder eines Gases durch eine Pipeline. Der Prozess 1 wird gesteuert und geregelt über dezentrale, anlagenseitige Automatisierungseinheiten 2, die zu diesem Zweck eine Reihe von Wirkverbindungen 3 zu in Figur 1 nicht näher dargestellten Sensoren und Aktoren des Prozesses aufweisen. Beispielhaft sind zwei Automatisierungseinheiten 2 gezeigt, in der Praxis werden mehrere Automatisierungseinheiten den Prozess steuern, regeln und überwachen. Über eine erste Datenverbindung 4 sind die Automatisierungseinheiten 2 mit dem Überwachungssystem 5 verbunden, welches die Steuerung und Überwachung des Prozesses 1 übernimmt. Die Automatisierungseinheiten 2 führen die prozesswirksamen Überwachungs- und Regelungsfunktionen 8 aus. In dieser Konfiguration ist das System 100 funktionsfähig und kann seine Steuer-, Regelungs- und Überwachungsaufgaben erfüllen. Das System 100 wird erweitert durch eine anlagenexterne Recheneinheit 6. Diese Recheneinheit ist über eine zweite Datenverbindung 14 mit den Automatisierungseinheiten 2 verbunden. Im vorliegenden Beispiel sind beide Automatisierungseinheiten 2 über die zweite Datenverbindung 14 mit der anlagenexternen Recheneinheit 6 verbunden. In anderen Ausführungsformen kann auch nur eine oder eine beliebige Anzahl von Automatisierungseinheiten mit der anlagenexternen Recheneinheit verbunden sein. Die zweite Datenverbindung 14 wird bevorzugt über das Internet entweder kabelgebunden oder drahtlos realisiert. Die anlagenexterne Recheneinheit 6 führt Prozessgrößenberechnungen 11 durch - beispielsweise laufen dort rechenintensivere Reglerstrukturen 7 oder parallele Simulationen, wobei die Ergebnisse der in der anlagenexternen Recheneinheit 6 durchgeführten Berechnungen über die Automatisierungskomponente 2 mittels der Umschalteinheit 9 prozesswirksam werden, indem die Umschalteinheit 9 von den ersten Prozessgrößenberechnungen 10 der eigenen Überwachungs- und Regelungsfunktionen 8 auf die anlagenexternen zweiten Prozessgrößenberechnungen 11 schaltet. Notwendige Eingangsgrößen 12 zur Durchführung von zweiten Prozessgrößenberechnungen 11 werden vom Programm, welches die Überwachungs- und Regelungsfunktionen 8 innerhalb der Automatisierungskomponente 2 ausführt, an ein Datenübertragungsmodul 13 übergeben, welches die Daten an die anlageexterne Recheneinheit 6 sendet. Im Idealfall handelt es sich bei dem Datenübertragungsmodul 13 um einen sog. Serviceagenten, welcher sich die Daten weitgehend selbstständig aus dem Programm oder Speicherbereichen akquiriert.

## Patentansprüche

1. System (100) zur Steuerung eines Prozesses (1), aufweisend anlagenseitig wenigstens eine Automatisierungseinheit (2), die eine Anzahl erster Prozessgrößenberechnungen (10) durchführt und auf den Prozess (1) einwirkt und mittels einer ersten Datenverbindung (4) mit einem Überwachungssystem (5) zur Steuerung und/oder Überwachung des Prozesses (1) verbunden ist,
das System wenigstens eine anlagenexterne Recheneinheit (6) aufweist, wobei die anlagenexterne Recheneinheit (6) über verteilte Kommunikationsmechanismen auf die wenigstens eine Automatisierungseinheit (2) aufgeschaltet ist und mit dieser über eine zweite Datenverbindung (14) in Datenaustausch steht und die anlagenexterne Recheneinheit (6) eine Anzahl zweiter Prozessgrößenberechnungen (11) durchführt, die über die Automatisierungseinheit (2) prozesswirksam werden,
**dadurch gekennzeichnet, dass** die Prozessgrößenberechnungen der anlagenseitigen Automatisierungseinheit in dem Umfang unwirksam werden, in dem die zweiten Prozessgrößenberechnungen der anlagenexternen Recheneinheit wirksam werden und die Steuerung der anlagenseitigen Prozessgrößen mittels der zweiten Prozessgrößenberechnungen erfolgt, wobei die Prozessbeeinflussung über die anlagenseitige Automatisierungseinheit erfolgt, d.h. die Ausgänge der anlagenseitigen Automatisierungseinheit aufgrund der Berechnungen in der anlagenexternen Recheneinheit geschalten werden.

2. System nach Anspruch 1, **dadurch gekennzeichnet, dass** die anlagenexterne Recheneinheit mit einer Anzahl weiterer anlagenexterner Recheneinheiten verbunden ist.

3. System nach Anspruch 1 oder 2, **dadurch gekennzeichnet, dass** wenigstens eine anlagenexterne Recheneinheit eingerichtet ist, um Simulationsaufgaben des Prozesses durchzuführen.

4. System nach Anspruch 3 **dadurch gekennzeichnet, dass** die Simulationsaufgaben in unterschiedlicher Optimierungsstrategien münden.

5. System nach Anspruch 4, **dadurch gekennzeichnet, dass** wenigstens eine der Simulationsstrategien dynamisch auf externe Einflussfaktoren reagiert.

6. System nach Anspruch 1 oder 2, **dadurch gekennzeichnet, dass** bei Störung der zweiten Datenverbindung die ersten Prozessgrößenberechnungen der anlagenseitigen Automatisierungseinheit ausgeführt werden.

7. System nach einem der vorhergehenden Ansprüche **dadurch gekennzeichnet, dass** wenigstens einer anlagenseitigen Automatisierungseinheit ein Serviceagent (13) zugeordnet ist, wobei der Serviceagent über die zweite Datenverbindung die anlagenexterne Recheneinheit mit Prozessdaten der anlagenseitigen Automatisierungseinheit versorgt und wobei der Serviceagent die zugeordnete Steuer- und/oder Regelungseinheit mit Prozessdaten der anlagenexternen Recheneinheit versorgt.

8. Verfahren zur Erweiterung wenigstens einer anlagenseitigen Automatisierungseinheit (2) zur Steuerung von Prozessgrö-ßen mit einer Anzahl von Automatisierungsfunktionen (8), wobei die Automatisierungseinheit (2) eine Anzahl erster Prozessgrößenberechnungen (10) umfasst und mittels einer ersten Datenverbindung (4) mit einem Überwachungssystem (5) zur Steuerung und/oder Überwachung des Prozesses verbunden ist, aufweisend die Schritte:
- programmtechnische Implementierung einer Anzahl von weiteren Automatisierungsfunktionen (7) für eine Anzahl zweiter Prozessgrößenberechnungen (11) in wenigstens einer anlagenexternen Recheneinheit (6)
- Aufschalten der wenigstens einen anlagenexternen Recheneinheit (6) über verteilte Kommunikationsmechanismen über eine zweite Datenverbindung (14) auf die wenigstens eine anlagenseitige Automatisierungseinheit (2) ,
- Durchführung der Anzahl zweiter Prozessgrößenberechnungen (11) in der anlagenexternen Recheneinheit (6) parallel zu der Anzahl erster Prozessgrößenberechnungen (10) in der anlagenseitigen Automatisierungseinheit
- Steuerung von anlagenseitigen Prozessgrößen mittels der Anzahl zweiter Prozessgrößenberechnungen (11) über die anlagenseitige Automatisierungseinheit (2), indem die Prozessgrößenberechnungen der anlagenseitigen Automatisierungseinheit in dem Umfang unwirksam werden, in dem die zweiten Prozessgrö-ßenberechnungen der anlagenexternen Recheneinheit wirksam werden und die Steuerung der anlagenseitigen Prozessgrößen mittels der zweiten Prozessgrößenberechnungen erfolgt, wobei die Prozessbeeinflussung über die anlagenseitige Automatisierungseinheit erfolgt, d.h. die Ausgänge der anlagenseitigen Automatisierungseinheit aufgrund der Berechnungen in der anlagenexternen Recheneinheit geschalten werden.

9. Verfahren nach Anspruch 8, **dadurch gekennzeichnet, dass** die weiteren Automatisierungsfunktionen (7) Simulationsaufgaben des Prozesses umfassen.

10. Verfahren nach Anspruch 9, **dadurch gekennzeichnet, dass** die zweiten Prozessgrößenberechnungen (11) der Simulationsaufgaben unterschiedliche Optimierungsstrategien für den Prozess umfassen.

11. Verfahren nach Anspruch einem der Ansprüche 8 bis 10 **dadurch gekennzeichnet, dass** die Steuerung von anlagenseitigen Prozessgrößen mittels der zweiten Prozessgrößenberechnung über die erste Datenverbindung (4) auf dem Überwachungssystem (5) überwacht wird.

12. Verfahren nach Anspruch 11 **dadurch gekennzeichnet, dass** bei Störung der zweiten Datenverbindung die ersten Prozessgrößenberechnungen die zweiten Prozessgrößenberechnungen ersetzen.

## Claims

1. System (100) for controlling a process (1) having at least one automation unit (2) on the plant side, which performs a number of first process variable calculations (10) and influences the process (1) and is connected by means of a first data link (4) to a monitoring system (5) for controlling and/or monitoring the process (1),
the system has at least one external computing unit (6), wherein the external computing unit (6) is connected by way of distributed communication mechanisms to the at least one automation unit (2) and exchanges data herewith by way of a second data link (14) and the external computing unit (6) performs a number of second process variable calculations (11) which influence the process by way of the automation unit (2), **characterised in that** the process variable calculations of the plant-side automation unit become ineffective to the extent that the second process variable calculations of the external computing unit become effective and in which the control of the plant-side process variables takes place by means of the second process variable calculations, wherein the process is influenced by way of the plant-side automation unit, i.e. the outputs of the plant-side automation unit are connected based on the calculations in the external computing unit.

2. System according to claim 1, **characterised in that** the external computing unit is connected to a number of further external computing units.

3. System according to claim 1 or 2, **characterised in that** at least one external computing unit is set up to perform simulation tasks of the process.

4. System according to claim 3, **characterised in that** the simulation tasks feed into different optimisation strategies.

5. System according to claim 4, **characterised in that** at least one of the simulation strategies reacts dynamically to external influencing factors.

6. System according to claim 1 or 2, **characterised in that** if there is a fault in the second data link, the first process variable calculations of the plant-side automation unit are executed.

7. System according to one of the preceding claims, **characterised in that** a service agent (13) is assigned to at least one plant-side automation unit, wherein the service agent supplies the external computing unit with process data from the plant-side automation unit by way of the second data link and wherein the service agent supplies the assigned control and/or regulation unit with process data from the external computing unit.

8. Method for extending at least one plant-side automation unit (2) for controlling process variables with a number of automation functions (8), wherein the automation unit (2) comprises a number of first process variable calculations (10) and is connected by means of a first data link (4) to a monitoring system (5) for controlling and/or monitoring the process, having the steps:
- program-based implementation of a number of further automation functions (7) for a number of second process variable calculations (11) in at least one external computing unit (6),
- connecting the at least one external computing unit (6) by way of distributed mechanisms via a second data link (14) to the at least one plant-side automation unit (2),
- performing the number of second process variable calculations (11) in the external computing unit (6) in parallel with the number of first process variable calculations (10) in the plant-side automation unit,
- controlling plant-side process variables by means of the number of second process variable calculations (11) by way of the plant-side automation unit (2), by the process variable calculations of the plant-side automation unit becoming ineffective to the extent that the second process variable calculations of the external computing unit become effective and in which the control of the plant-side process variables takes place by means of the second process variable calculations, wherein the process is influenced by way of the plant-side automation unit, i.e. the outputs of the plant-side automation unit are connected based on the calculations in the external computing unit.

9. Method according to claim 8, **characterised in that** the further automation functions (7) comprise simulation tasks of the process.

10. Method according to claim 9, **characterised in that** the second process variable calculations (11) of the simulation tasks comprise different optimisation strategies for the process.

11. Method according to one of claims 8 to 10, **characterised in that** the control of plant-side process variables is monitored on the monitoring system (5) by means of the second process variable calculation via the first data link (4).

12. Method according to claim 11, **characterised in that** if there is a fault in the second data link, the first process variable calculations replace the second process variable calculations.

## Revendications

1. Système (100) pour le contrôle d'un processus (1), comprenant, côté installation, au moins une unité d'automatisation (2), qui effectue un nombre de premiers calculs de grandeurs de processus (10) et agit sur le processus (1) et est relié, au moyen d'une première liaison de données (4), avec un système de surveillance (5) pour le contrôle et/ou la surveillance du processus (1),
le système comprend au moins une unité de calcul extérieure à l'installation (6), dans lequel l'unité de calcul extérieure à l'installation (6) est branchée, par l'intermédiaire de mécanismes de communication répartis, à l'au moins une unité d'automatisation (2) et est relié par un échange de données avec celle-ci par l'intermédiaire d'une deuxième liaison de données (14) et l'unité de calcul extérieure à l'installation (6) effectue un nombre de deuxièmes calculs de grandeurs de processus (11) qui agissent sur le processus par l'intermédiaire de l'unité d'automatisation (2),
**caractérisé en ce que** les calculs de grandeurs de processus de l'unité d'automatisation côté installation sont inactifs dans la mesure où les deuxièmes calculs de grandeurs de processus de l'unité de calcul extérieure à l'installation sont actifs et le contrôle des grandeurs de processus côté installation a lieu au moyen des deuxièmes calculs de grandeurs de processus, dans lequel le contrôle du processus a lieu par l'intermédiaire de l'unité d'automatisation côté installation, c'est-à-dire que les sorties de l'unité d'automatisation côté installation sont commutées sur la base des calculs dans l'unité de calcul extérieure à l'installation.

2. Système selon la revendication 1, **caractérisé en ce que** l'unité de calcul extérieure à l'installation est reliée avec un nombre d'autres unités de calcul extérieures à l'installation.

3. Système selon la revendication 1 ou 2, **caractérisé en ce qu'**au moins une unité de calcul extérieure à l'installation est conçue pour effectuer des tâches de simulation du processus.

4. Système selon la revendication 3, **caractérisé en ce que** les tâches de simulation conduisent à différentes stratégies d'optimisation.

5. Système selon la revendication 4, **caractérisé en ce qu'**au moins une des stratégies de simulation réagit de manière dynamique à des facteurs d'influence externes.

6. Système selon la revendication 1 ou 2, **caractérisé en ce que**, lors d'un dysfonctionnement de la deuxième liaison de données, les premiers calculs de grandeurs de processus de l'unité d'automatisation côté installation sont effectués.

7. Système selon l'une des revendications précédentes, **caractérisé en ce que**, à au moins une unité d'automatisation côté installation, correspond un agent de service (13), dans lequel l'agent de service alimente, par l'intermédiaire de la deuxième liaison de données, l'unité de calcul extérieure à l'installation en données de processus de l'unité d'automatisation côté installation et dans lequel l'agent de service alimente l'unité de commande et/ou de régulation correspondant avec des données de processus de l'unité de calcul extérieure à l'installation.

8. Procédé d'extension d'au moins une unité d'automatisation côté installation (2) pour le contrôle de grandeurs de processus avec un nombre de fonctions d'automatisation (8), dans lequel l'unité d'automatisation (2) comprend un nombre de premiers calculs de grandeurs de processus (10) et est reliée, au moyen d'une première liaison de données (4), avec un système de surveillance (5) pour le contrôle et/ou la surveillance du processus, comprenant les étapes suivantes :
- implémentation par programme d'un nombre d'autres fonctions d'automatisation (7) pour un nombre de deuxièmes calculs de grandeurs de processus (11) dans au moins une unité de calcul extérieure à l'installation (6),
- mise en ligne de l'au moins une unité de calcul extérieure à l'installation (6) par l'intermédiaire de mécanisme de communication répartis, par l'intermédiaire d'une deuxième liaison de données (14), avec l'au moins une unité d'automatisation côté installation (2),
- réalisation du nombre de deuxièmes calculs de grandeurs de processus (11) dans l'unité de calcul extérieure à l'installation (6) parallèlement au nombre de premiers calculs de grandeurs de processus (10) dans l'unité d'automatisation côté installation,
- contrôle de grandeurs de processus côté installation au moyen du nombre de deuxièmes calculs de grandeurs de processus (11) par l'intermédiaire de l'unité d'automatisation côté installation (2), grâce au fait que les calculs de grandeurs de processus côté installation sont inactifs dans la mesure où les deuxièmes calculs de grandeurs de processus de l'unité de calcul extérieure à l'installation sont actifs et le contrôle des grandeurs de processus côté installation a lieu au moyen des deuxièmes calculs de grandeurs de processus, dans lequel le contrôle du processus a lieu par l'intermédiaire de l'unité d'automatisation côté installation, c'est-à-dire que les sorties de l'unité d'automatisation côté installation sont commutées sur la base des calculs dans l'unité de calcul extérieure à l'installation.

9. Procédé selon la revendication 8, **caractérisé en ce que** les autres fonctions d'automatisation (7) comprennent des tâches de simulation du processus.

10. Procédé selon la revendication 9, **caractérisé en ce que** les deuxièmes calculs de grandeurs de processus (11) des tâches de simulation comprennent différentes stratégies d'optimisation pour le processus.

11. Procédé selon l'une des revendications 8 à 10, **caractérisé en ce que** le contrôle des grandeurs de processus côté installation est surveillé au moyen du deuxième calcul de grandeurs de processus par l'intermédiaire de la première liaison de données (4) sur le système de surveillance (5).

12. Procédé selon la revendication 11, **caractérisé en ce que**, lors d'un dysfonctionnement de la deuxième liaison de données, les premiers calculs de grandeurs de processus remplacent les deuxièmes calculs de grandeurs de processus.
